# EUROPEAN PATENT SPECIFICATION

(11) **EP 1 566 995 B1**
(45) Date of publication and mention of the grant of the patent: **15.08.2007**
(21) Application number: 04003951.3
(22) Date of filing: 20.02.2004
(51) Int. Cl.: H05K 13/08, H05K 1/02, H05K 3/34

(54) **Surface mount technology evaluation board**
Testplatte für die Oberflächenmontagetechnologie
Carte d'évaluation pour la technique de montage en surface

(43) Date of publication of application: 24.08.2005
(73) Proprietor: Research In Motion Limited, Waterloo, Ontario N2L 3W8 (CA)
(72) Inventor: Connell, David James, Brantford Ontario N3R 6T4 (CA); Christian, Beverley Howard, Waterloo Ontario N2V 1X4 (CA)
(74) Representative: Rickard, David John

(56) References cited:
- EP-A- 0 779 774
- EP-A- 0 926 930
- WO-A-98/42167
- DE-A- 19 910 407
- US-A- 4 467 638
- US-A- 5 457 880
- PATENT ABSTRACTS OF JAPAN vol. 1998, no. 14, 31 December 1998 (1998-12-31) -& JP 10 256722 A (SONY CORP), 25 September 1998 (1998-09-25)
- PATENT ABSTRACTS OF JAPAN vol. 016, no. 031 (E-1159), 27 January 1992 (1992-01-27) & JP 03 244188 A (FUJITSU LTD), 30 October 1991 (1991-10-30)
- PATENT ABSTRACTS OF JAPAN vol. 017, no. 639 (M-1515), 26 November 1993 (1993-11-26) & JP 05 200991 A (MATSUSHITA ELECTRIC IND CO LTD), 10 August 1993 (1993-08-10)

## Description

### Field of the invention

The invention relates to an evaluation board that can be used to evaluate certain aspects of the surface mount technology process. More particularly, this invention relates to an evaluation board that can be used to evaluate solder paste, stencil and circuit board manufacturing, and the printing and reflow processes used in surface mount technology.

### Background of the invention

Electronic devices are typically manufactured by mounting electronic components on a printed circuit board (PCB) using surface mount technology (SMT). The electronic components generally have leads, balls or conductive pads (i.e. component pads) that make electrical and mechanical contact with corresponding conductive pads (i.e. board pads) on a surface of a PCB. The process that is used for attaching the electronic components to the PCB includes the stages of solder paste deposition (i.e. printing) on the PCB through a stencil, component placement on the pasted PCB and reflow or heating the PCB. For a double-side PCB, the PCB is then turned upside down and these steps are performed again.

The PCB is manufactured by a circuit board manufacturer according to the specifications that are provided by an electronic device manufacturer. Likewise, the stencil is manufactured by a stencil manufacturer according to the specifications that are provided by the electronic device manufacturer.

Solder paste deposition involves the use of a screen printer for depositing solder paste on the board pads that are located on the surface of the PCB. In this stage, the stencil is positioned over the surface of the PCB that contains the board pads with the stencil being aligned with the PCB in a predetermined orientation. The stencil has a thickness and apertures with specific tolerances. A squeegee blade, or a Proflow™ or Rheometric™ pump, or a dispensing needle, as is commonly known to those skilled in the art, is then used to apply the solder paste to the PCB through the stencil.

Component placement includes placing electronic components, such as QFPs (quad flat package), SOPs (small outline package), chips, BGAs (Ball Grid Array), CSPs (Chip Scale Package), and the like, on the surface of the PCB such that the leads or component pads of each of the electronic components align with the corresponding board pads covered with solder paste or paste flux on the PCB surface. The reflow process consists of inserting the PCB into a reflow furnace and using a certain reflow profile for heating the PCB to cause the solder paste, and any solder that makes up part of the board pad and/or lead finish, to melt and then allowing the PCB to cool such that the solder solidifies and there is mechanical and electrical contact between component pads and the corresponding board pads. The amount of heat that is applied and the length of the heating and cooling period in the reflow profile depend on the type of solder paste that is used, the thermal mass of the product, component temperature limitations and line cycle time.

Manufacturing defects can occur during the solder paste deposition, component placement and reflow stages of the SMT process. However, typically 60 to 70% of the defects occur during the solder paste deposition stage. Accordingly, it is necessary to routinely inspect the deposited solder paste on the PCB to determine if there are any defects such as missing solder paste, improper solder paste coverage on a board pad and solder paste bridging. These defects may occur for a variety of reasons. For instance, the particular solder paste that is used may not be suitable for adhering to a board pad on the PCB given the operating conditions used in the solder paste deposition stage or the stencil may be clogged. Alternatively, there may be too much or too little solder paste that is deposited. Once again this depends on the type of solder paste used and/or the operating conditions of the solder paste deposition process. If too much solder paste is deposited, then the board pad may be in electrical contact with more than one component pad on the electronic component following the reflow process. Also, solder paste on adjacent board pads on the PCB may merge together thereby forming an electrical short circuit or bridge between the adjacent board pads. If too little solder paste is deposited, then poor mechanical and/or electrical contact between the board pad and the corresponding component pad may result. Other defect which may occur includes voids, which are bubbles that are suspended in solidified solder. A void is formed from entrapped air and/or outgasing of materials from at least one of the board pads, the component pads and solvents from the solder paste.

In addition, in surface mount technology, there is an increasing drive towards electronic components that are smaller, cheaper and provide more functionality. Accordingly, an increased number of smaller electronic components are incorporated onto one or both surfaces of a PCB. These smaller electronic components have smaller component pad sizes and smaller pad-to-pad spacing (i.e. the distance between adjacent component pads). This size reduction has stretched the capabilities of screen printing equipment and solder paste and increased the incidence of defects in the SMT manufacturing process. Accordingly, this size reduction has required changes in the various stages of the SMT process such as using a suitable solder paste and being able to deposit the solder paste on smaller board pads.

It is known from Patent Abstracts of Japan, vol. 1998, No. 14, 31st December 1998 and Japanese Patent Publication JP 10 256722 A to provide a board for evaluating the processing of solder spread and suck-up properties, the board comprising: a solder paste printed on a CU foil pattern of a printed wiring board and molted solder is made to flow through holes of the wiring board to solder, in a flow soldering process. The arrangement is such that the board pads of some of the board pad patterns are of uniform shape, size and pad to pad spacing and are arranged in a single row or column within their respective board pad patterns and the sizes of the board pads of adjacent board pad patterns changes progressively.

US-A-4467638 discloses a test board for testing the soldering properties of a wave soldering system, the board having a pair of parallel strips of a solderable material such as copper, one of said strips is formed as a continuous length and the other as a discontinuous strip. The test board is partially immersed into a solder wave whereby the point of maximum direct contact with the solder of the wave is determined from the discontinuous strip. However, there is no teaching relating to the shape or spacing or placement of board pads or of the importance of these; the test board does not disclose an arrangement where the board pads of each of the board pad patterns are arranged in multiple rows and columns and have a uniform shape, size and pad to pad spacing or where the board pads of adjacent board pad patterns progressively change and does not disclose the importance or use of these elements.

### GENERAL

In a first main aspect, the present invention provides an evaluation board for evaluating one or more aspects of a surface mount technology system, the board comprising: a substrate having a surface; a plurality of board pad patterns formed on the surface, wherein at least some of the board pad patterns are arranged in a matrix and each of the board pad patterns in the matrix includes a plurality of board pads having a uniform shape, size and pad-to-pad spacing, characterized in that for each of said board pad patterns in the matrix, the board pads are arranged in multiple rows and multiple columns and the size and/or pad-to-pad spacing of board pads of adjacent board pad patterns progressively changes through the matrix.

In another aspect, the evaluation board is characterized in that the shape of the boards pads of at least one of the plurality of board pad patterns differs from the shape of the board pads of at least one other of the plurality of board pad patterns.

In another aspect, the evaluation board is characterized in that some of the board pad patterns are arranged in a two dimensional matrix having rows and columns of board pad patterns, wherein, in each row of the matrix, a characteristic of the board pads of adjacent board pad patterns of that row is varied and wherein, for each column of the matrix, a characteristic of the board pads of adjacent board pad patterns of that column is varied.

In another aspect, the evaluation board is characterized in that the board pad patterns of the rows and columns of the matrix comprises any one of or a combination of the shape, size or pad-to-pad spacing of the boards pads of said board pad patterns.

In another aspect, the evaluation board is characterized in that the boards pads of the board pad patterns of the rows of the matrix that is varied is different to the characteristic varied for the board pads of the board pad patterns of the columns of the matrix.

In another aspect, the evaluation board is characterized in that the substrate has two surfaces and wherein each surface has a plurality of board pad patterns formed on it.

In another aspect, the evaluation board is characterized in that the substrate has two surfaces, wherein the first surface has a plurality of board pad patterns formed of board pads and the second surface has a plurality of area-filled board pads.

In another aspect, the evaluation board is characterized in that the size and/or pad-to-pad spacing of adjacent area-filled board pads progressively changes.

In another aspect, the evaluation board is characterized in that some of the area-filled board pads are arranged in a matrix wherein the size and/or pad-to-pad spacing of adjacent area-filled board pads progressively changes through the matrix.

In another aspect, the evaluation board is characterized in that some of the area-filled board pads are arranged in a two dimensional matrix comprising rows and columns of said area-filled board pads, wherein, in each row of the matrix, a characteristic of adjacent area-filled board pads of that row is varied and wherein, for each column of the matrix, a characteristic of adjacent area-filled board pads of that column is varied.

In another aspect, the evaluation board is characterized in that the characteristic of the area-filled boards pads of the rows of the matrix that is varied is different to the characteristic varied for the area-filled board pads of the columns of the matrix.

In another aspect, the evaluation board is characterized in that the substrate has two surfaces and wherein each surface has a plurality of area-filled board pad formed on it.

In another aspect, the evaluation board is characterized in that the substrate has two surfaces, wherein the first and the second surfaces have a plurality of board pad patterns formed of board pads.

In a second main aspect, the present invention provides a method of evaluating one or more aspects of a surface mount technology system using the evaluation board of the first main aspect of the invention wherein said method comprises the steps of: passing the evaluation board through at least one stage of a surface mount technology process; and inspecting the board on completion of said at least one stage of the surface mount technology process.

In a third main aspect of the invention, there is provided a stencil for an evaluation board of the first main aspect of the invention, wherein the stencil comprises a plurality of apertures having sizes and spacing that correspond with the board pad sizes and pad-to-pad spacing of the board pads on the evaluation board.

### Brief description of the drawings

For a better understanding of the present invention and to show more clearly how it may be carried into effect, reference will now be made, by way of example only, to the accompanying drawings which show an exemplary embodiment of the present invention and in which:

Figure 1 is a top view of a surface of an evaluation board in accordance with the present invention;

Figure 2 is a top view of a surface of an alternative embodiment of an evaluation board in accordance with the present invention;

Figure 3 is a graphical illustration of terminology used to describe board pads on the evaluation board of the present invention;

Figures 4a-4e are a series of diagrams showing several cases of solder paste deposition on a board pad; and,

Figures 5a-5g are a series of diagrams showing several different embodiments for the board pads on the evaluation board.

### Detailed description of the invention

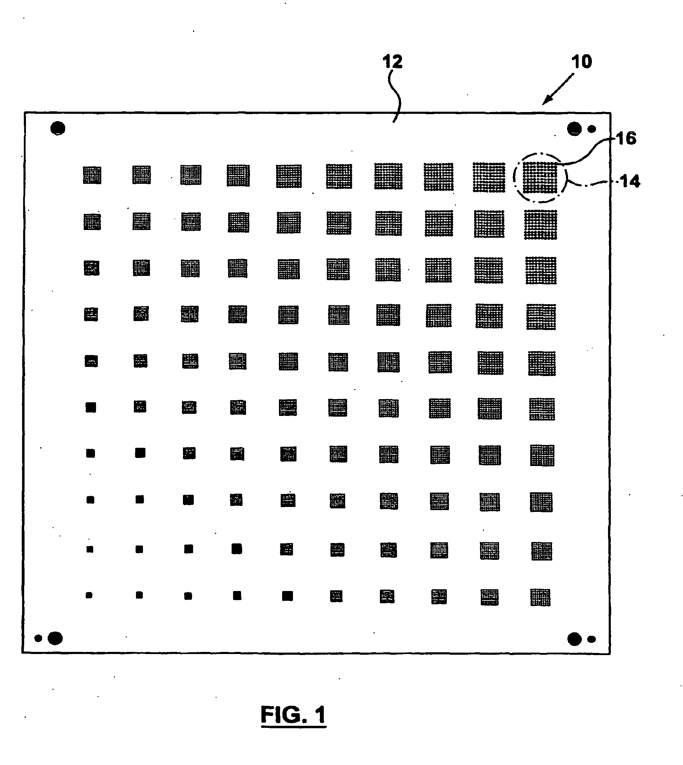

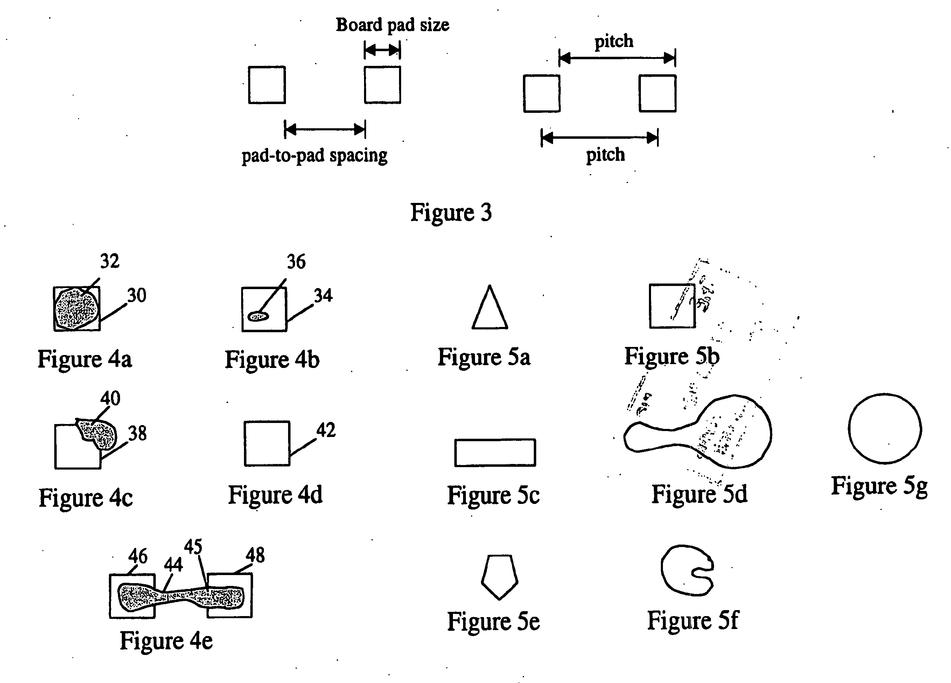

Referring first to Figure 1, shown therein is a top view of an evaluation board **10** for surface mount technology in accordance with the present invention. Evaluation board **10** provides a substrate for a surface **12.** On surface **12,** there are a plurality of board pad patterns **14.** Each board pad pattern **14** comprises a plurality of board pads **16** (only one board pattern and only one board pad is labeled for simplicity). Each board pad **16** is a conductive metallic material such as copper or gold which is provided on the surface **12** of the evaluation board **10** using circuit board manufacturing techniques that are well known to those skilled in the art. Each board pad **16** may have a rectangular, paralleliped, square, circular or other shape as illustrated in Figures 5a-5g. Alternatively, some of the board pads **16** on the evaluation board **10** may have a rectangular shape while others may have a square, paralleliped or circular shape. The shape can be chosen to correspond with the shape of the component pads (i.e. circular-shaped pads are suitable for BGAS and CSPs).

There are a number of board pads **16** in each board pad pattern **14** to facilitate the generation of test statistics. In the exemplary evaluation board **10,** there are 100 board pads **16** in a given board pad pattern **14.** However, the same number of board pads **16** does not have to be used in each board pad pattern **14** on the evaluation board **10.**

The evaluation board **10** is designed such that the size of the board pads **16** in the board pad patterns **14** (i.e. hereafter referred to as the board pad size) and the pad-to-pad spacing of the board pads **16** in the board pad patterns **14** are varied over the surface of the evaluation board **10.** Figure 3 provides an illustrative explanation of board pad size and pad-to-pad spacing. In the particular exemplary embodiment of the evaluation board **10** shown in Figure 1, referenced such that board pad pattern **16** is at the upper right-hand corner, a matrix of board pad patterns **14** is provided in which, for a given row, the board pad size in a given board pad pattern is constant and the pad-to-pad spacing used in successive board pad patterns **14** is reduced in size while moving from right to left. For a given column of the matrix, the board pad size for successive board pad patterns **14** is reduced while moving from top to bottom and the pad-to-pad spacing used in each board pad pattern **14** remains constant. Accordingly, it should be understood that when moving along a straight horizontal line (i.e. row) from the bottom left of Figure 1, that the pad-to-pad spacing is increased by 0.05mm (in this example) along successive boards patterns while the pad size stays constant. It should also be understood that when moving along a straight vertical line (i.e. column) from the bottom of Figure 1, that the pad size is increased by 0.05mm (in this example) along successive board patterns while the pad-to-pad spacing stays constant. It should also be understood that if pitch is a factor that is to be looked at, in the matrix of Figure 1, diagonal lines can be drawn along pads that have the same pitch with differing pad sizes.

**The variation in board pad size and pad-to-pad spacing allows** for testing the SMT process for producing electronic devices of various sizes. For instance, the board pad size and pad-to-pad spacing may be varied from a size that is larger than those that are currently used in electronic device manufacturing, to sizes that are currently used in electronic device manufacturing, to smaller sizes that will be used for future electronic device manufacturing. This allows the evaluation board **10** to be used for future generations of surface mount technology. An exemplary range of values for board pad size and pad-to-pad spacing that can be used with the evaluation board **10** is approximately 0.5 mm to 50 µm. This range includes the industry standard that is currently used which is a board pad size of 0.25 mm and a pad-to-pad spacing of 0.3 mm for the current CSP and mini BGA package types. By incorporating very small board pad sizes and pad-to-pad spacing, the evaluation board **10** also can be used to test various stages of the SMT process for failure such as the solder paste that is used, and the ability of the circuit board manufacturers and stencil manufacturers to respectively provide circuit boards and stencils to accommodate such small board pad sizes and pad-to-pad spacings. This allows for the determination of which solder paste, stencil and or circuit board designs and manufacturers are suitable for current or future electronic products.

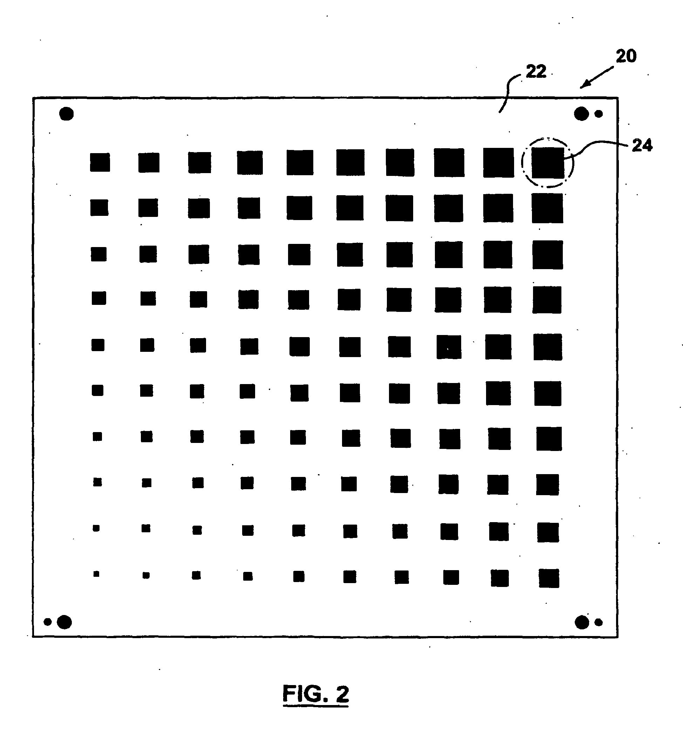

Referring now to Figure 2, shown therein is an alternate embodiment of an evaluation board **20** in accordance with the present invention. On a surface **22** of the evaluation board **20,** there are a plurality board pad patterns that have been filled in. The board pad patterns are referred to as area-filled pads **24,** one of which is labeled for simplicity. Each area-filled pad **24** is a conductive metallic material such as copper or gold and may have a rectangular, paralleliped, square, circular or other shape (see Figures 5a-5g). Alternatively, some of the area-filled pads **24** on the evaluation board **20** may have a rectangular shape while others may have a square, paralleliped or circular shape.

In the particular exemplary embodiment of the evaluation board **20** shown in Figure 2, a matrix of area-filled pads is provided in which, for a given row, the size of the area-filled pad is reduced while moving from right to left whereas for a given column of the matrix, the size of the area-filled pad is reduced while moving from top to bottom. The size of the area-filled pads **24** may correspond to the sizes of the board pad patterns **14** of evaluation board **10**. In addition, in the example of Figure 2, the pad-to-pad spacing of the area-filled pads is reduced along both the row and columns of the matrix. However, this need not be the case, and the same pad-to-pad spacing can be used along a given direction (i.e. row or column) of the matrix.

An evaluation board may have the board pad patterns of evaluation board **10** or evaluation board **20** on a single surface. Alternatively, an evaluation board may be double sided and have the board pad patterns of evaluation board **10** on each surface, the board pad patterns of evaluation board **20** on each surface or the board pad patterns of evaluation board **10** on one of the surfaces and the board pad patterns of evaluation board **20** on the other surface.

The evaluation boards **10** and **20** have been designed in an attempt to standardize paste/stencil/circuit board manufacturing. The evaluation board **10** can be used to effect SMT process trouble-shooting (one example being furnace profile optimization), for defect reduction and for manufacturability improvements. The evaluation board **10** can also be used to test the performance of different solder paste formulations that are provided by different manufacturers or the performance of different solder paste formulations provided by the same manufacturer for a given board pad size and pad-to-pad spacing as well as different printing and/or reflow parameters. The printability and wettability of the solder paste can also be investigated.

Evaluation board 10 may be used to conduct a variety of tests such as aperture tests, spread/slump tests and determination of solder sphere size applicability to a particular process/project. Aperture tests involve using the different pad-to-pad spacings of the evaluation board **10** to test the fine pitch capability of a particular solder paste formulation which could include a different powder and or flux formulation. Solder paste is the combination of solder spheres that are in a range of sizes for each particular solder sphere type (there are types 1-6 with type 3 being the most common). A higher type number corresponds to a smaller solder sphere size range which is also more expensive. The spread/slumping test can be used to test the slumping that occurs during the solder paste deposition (i.e. printing) stage of the SMT process and throughout the entire placement process until the solder paste is melted into solder. The different spacing of the solder paste on adjacent pads on the evaluation board 10, as a result of the different pad-to-pad spacing, can provide an indication of the severity of slumping. In addition, the proper solder sphere size in a solder paste needed to properly cover a particular board pad size on the evaluation board 10 can be determined.

These various tests can be scored by observing the number of open pads and shorted pads (i.e. bridging) that occurs during various stages of the SMT process. The observation can be visually made through manual means (i.e. looking at the evaluation board with a high resolution microscope) or automated visual inspection means as is commonly known to those skilled in the art. The visual observations can be made since the solder paste usually consists of gray spheres in a usually clear organic gel and the board pads are typically either a reddish brown (copper) or a yellow (gold color). Accordingly, there is a good contrast between the solder paste and the board pads.

An open pad is a board pad that has no solder paste on it. Open pads provide an indication of the printability of the solder paste, the performance of the screen printer, stencil and/or the printing conditions. Open pads may also be examined after the reflow stage where the same conditions can be gauged as well as the ability of the solder paste to flow out and totally cover the pads and/or the effect of different reflow profile conditions.

A short can be the result of solder paste slumping in which the forces of gravity and the cohesive forces of the solder paste result in the solder paste spreading out and flattening so that two board pads are connected by the solder in the solder paste. This may occur because of the amount of solder paste, the amount/type of activated solder flux, the ratio of solder to flux, the board finish and/or the reflow profile conditions. Shorts can be checked for different board pad sizes, different pad-to-pad spacing and different reflow profiles. The evaluation board 10 can also be used to determine if there is a propensity of shorts in one region or another of the evaluation board **10**. Shorts can also occur after the solder paste has melted.

Referring now to Figures 4a-4e, shown therein are several cases of deposited solder paste (i.e. a solder paste brick) on a board pad. Figure 4a shows a preferable case in which a board pad **30** is adequately covered with a solder paste brick **32**. Figure 4b shows a case in which a board pad **34** is not adequately covered by a solder paste brick **36** (too little solder paste has been deposited). Figure 4c shows a case in which a board pad **38** is also not adequately covered by a solder paste brick **40**. In this case, enough solder paste has been deposited but it was incorrectly deposited partly outside of the board pad **38**. Figure 4d shows a case of an open pad **42** in which no solder paste has been deposited on the board pad **42**. Figure 4e shows a case of a short in which solder paste **44** and **45** from two adjacent board pads **46** and **48** have slumped together, shorting them together.

The evaluation board **20** may be used to provide test data on voids that occur for a particular solder paste formulation under certain SMT process parameters. In particular, the evaluation board **20** allows for the variation of stencil aperture and solder paste formulation to obtain an understanding of how large the board pad size and which pattern of board pad can be used without generating voids. Voids can form when a termination is placed on a solder pasted pad and put through the reflow process and there is either insufficient solder paste to cover the entire surface or the out gassing of the volatiles in the solder paste, board pad or component termination gets trapped when the solder paste is melted and then solidifies. In addition, the evaluation board **20** can be used to determine which solder paste formulation is better for reducing voids under certain SMT process parameters. X-ray techniques, as is commonly known to those skilled in the art, can be used to visually inspect for void formation. The evaluation board **20** can also be used for wetting tests to determine how much a particular solder paste formulation spreads or slumps after being applied to a PCB.

In addition, the evaluation boards **10** and **20** have features that mimic circuit boards that are used for manufacturing electronic devices. The evaluation boards **10** and **20** include solder masks in between the board pads. The evaluation boards **10** and **20** further comprise multiple alternating layers of fiberglass/epoxy and copper. This is advantageous for testing solder paste formulations that require different temperatures during the reflow stage. For instance, lead-free solder paste formulations require a higher temperature during the reflow process. The multi-layer construction of the evaluation boards **10** and **20** curtail the evaluation boards **10** and **20** from warping under the higher temperature. The multi-layer construction allows for the usage of actual reflow parameters that would usually be used during an actual SMT process which allows the solder paste to react as it would during an actual SMT process.

Another parameter that can be varied on the evaluation boards **10** and **20** for SMT process evaluation is the finish that is used on the evaluation board. For instance, a different finish, such as ENIG (Electroless Nickel Immersion Gold) or OSP (Organic Solderability Preservative) can be used to observe the effect of test board finish on a particular solder paste formulation that is being evaluated. An ENIG board is made by producing a board with copper pads by methods well known by those versed in the art. The boards are then put into the proper nickel containing bath for a predetermined length of time to deposit a specific range of nickel thickness by electrochemical means. After proper rinsing, the boards are then put into a gold containing electrochemical bath where the gold atoms spontaneously replace the surface nickel atoms until the entire nickel surface areas are covered by gold. An OSP board is made by producing a board with copper pads by methods well known by those versed in the art. The boards are then immersed in a water solution of chemicals that bond to the copper to form a layer of organocopper molecules that will protect the surface copper from oxidation over the length of time guaranteed by the board manufacturer.

Another advantage of the evaluation boards **10** and **20** is the square shape of the board which allows the board, and the stencil, to be rotated a multiple of 90 degrees (i.e. 90, 180, 270) and inserted into the SMT screen printer (the machine that applies the solder paste). This allows for evaluating different angles of the SMT printer so that for the machine it can be confirmed that there is no difference of process along both axes. For instance this feature allows for evaluating the effect of squeegee printing (top of stencil) and underside cleaning (bottom of the stencil) in different directions on the evaluation board **10(20).**

In summary, the evaluation board **10** allows for a number of different tests to be conducted regarding SMT processing. In particular, the evaluation board **10** allows one to test:
1) the circuit board manufacturer's ability to create a circuit board with desired board pad sizes and pad-to-pad spacing;
2) the stencil manufacturer's ability to create a stencil with apertures having sizes and spacing that correspond with the board pad sizes and pad-to-pad spacing as well as different stencil manufacturing techniques (since for smaller apertures, a thinner stencil is required);
3) different printing and reflow environments with respect to the variables of time, temperature, humidity and the like;
4) different screen printer machines and screen printer parameters such as speed, pressure, etc. so that when a manufacturing company decides to buy equipment, the manufacturing company can evaluate different machines using the evaluation board to determine if the machine is going to meet current and future manufacturing needs;
5) printability of different solder pastes (i.e. different suppliers, different chemical formulations, different solder paste sphere size, etc.);
6) solder paste slump under both hot and cold conditions;
7) solder paste shorting;
8) insufficient solder paste;and,
9) solder shorts.
These test results can be evaluated in terms of the number of open and shorted pads for a given board pad size and pad-to-pad spacing.

In particular, when testing for slumping of solder paste or for pads that are shorted, the following guidelines can be followed:
1) Find rows and columns where the slumps or shorting occurs;2) The smaller the pad-to-pad spacing and the board pad size where the slumping or shorting occurs, the better the paste, printer, printing conditions, etc.;
3) The rows and columns can be numbered to rate the solder paste. Slumping that causes a connection between two board pads is unwanted and the higher the number of connections between board pads (i.e. shorting), the worse the result

In particular, when testing for open board pads the following guidelines can be followed:
1) Find rows and columns where the opens occur;
2) The smaller the pad-to-pad spacing and the board pad size where the slumping or shorting occurs, the better the paste, printer, printing conditions, etc.;
3) The rows and columns can be numbered to rate the solder paste. Open board pads are unwanted; the higher the number of open board pads, the worse the result.
Open board pads can be defined as complete or incomplete at the time of printing or reflow. For complete open board pads, in either the printing or reflow stage, solder paste is not at all present on a board pad. For incomplete open board pads at the printing stage, solder paste is present, but it is not covering all of the area of the board pad as expected. For incomplete open board pads at the reflow stage, reflowed solder paste has not flowed out to cover the expected area of the board pad.

It should be understood that various modifications can be made to the embodiments described and illustrated herein, without departing from the present invention, the scope of which is defined in the appended claims. For instance, the board pad patterns do not have to be arranged in a two-dimensional array. Other geometries could be used with repeatable patterns in which at least one of the board pad size and the pad-to-pad spacing is changed between each pattern.

In addition, there are many different shapes that can be used for the board pads as depicted in Figures 5a-5f. The board pad may be triangular (Figure 5a), square (Figure 5b), rectangular (Figure 5c), dog-bone or dumbbell shaped (Figure 5d), pentagonally shaped (Figure 5e), C-shaped (Figure 5f) or circular (Figure 5g). In each of these cases, the shape may be rotated and the aspect ratio of the shape is variable. The dumbbell/dog-bone shape is particularly advantageous in determining open board pads under BGAs and CSPs. The dumbbell/dog-bone shape has a first circular member and a second, smaller circular member. The amount of solder paste that flows out from the larger, first circular member to the smaller, second circular member provides an indication of whether the board pad is open.

## Claims

1. An evaluation board (10) for evaluating one or more aspects of a surface mount technology system, the board comprising:
a substrate having a surface (12);
a plurality of board pad patterns (14) formed on the surface (12), wherein at least some of the board pad patterns (14) are arranged in a matrix and each of the board pad patterns (14) in the matrix includes a plurality of board pads (16) having a uniform shape, size and pad-to-pad spacing,
**characterized in that** for each of said board pad patterns (14) in the matrix, the board pads (16) are arranged in multiple rows and multiple columns and the size and/or pad-to-pad spacing of board pads (16) of adjacent board pad patterns (14) progressively changes through the matrix.

2. The evaluation board (10) of claim 1 wherein the shape of the boards pads (16) of at least one of the plurality of board pad patterns (14) differs from the shape of the board pads (16) of at least one other of the plurality of board pad patterns (14).

3. The evaluation board (10) of any one of claims 1 to 2 wherein some of the board pad patterns (14) are arranged in a two dimensional matrix having rows and columns of board pad patterns (14), wherein, in each row of the matrix, a characteristic of the board pads (16) of adjacent board pad patterns (14) of that row is varied and wherein, for each column of the matrix, a characteristic of the board pads (16) of adjacent board pad patterns (14) of that column is varied.

4. The evaluation board (10) of claim 3 wherein the characteristic for the board pad patterns (14) of the rows and columns of the matrix comprises any one of or a combination of the shape, size or pad-to-pad spacing of the boards pads (16) of said board pad patterns (14).

5. The evaluation board (10) of claim 3 or claim 4 wherein the characteristic of the boards pads (16) of the board pad patterns (14) of the rows of the matrix that is varied is different to the characteristic varied for the board pads (16) of the board pad patterns (14) of the columns of the matrix.

6. The evaluation board (10) of any one of claims 1 to 5 wherein the substrate has two surfaces (12, 22) and wherein each surface (12, 22) has a plurality of board pad patterns (14) formed on it.

7. The evaluation board (10) of any one of claims 1 to 6 wherein the substrate has two surfaces (12, 22), wherein the first surface (12) has a plurality of board pad patterns (14) formed of board pads (16) and the second surface (22) has a plurality of area-filled board pads (24).

8. The evaluation board (20) of claim 7 wherein the size and/or pad-to-pad spacing of adjacent area-filled board pads (24) progressively changes.

9. The evaluation board (20) of claim 7 or claim 8 wherein some of the area-filled board pads (24) are arranged in a matrix wherein the size and/or pad-to-pad spacing of adjacent area-filled board pads (24) progressively changes through the matrix.

10. The evaluation board (20) of any one of claims 7 to 9 wherein some of the area-filled board pads (24) are arranged in a two dimensional matrix comprising rows and columns of said area-filled board pads (24), wherein, in each row of the matrix, a characteristic of adjacent area-filled board pads (24) of that row is varied and wherein, for each column of the matrix, a characteristic of adjacent area-filled board pads (24) of that column is varied.

11. The evaluation board (20) of claim 10 wherein the characteristic of the area-filled boards pads (24) of the rows of the matrix that is varied is different to the characteristic varied for the area-filled board pads (24) of the columns of the matrix.

12. The evaluation board (20) of any one of claims 7 to 11 wherein the substrate has two surfaces (22) and wherein each surface has a plurality of area-filled board pad (24) formed on it.

13. The evaluation board (10) of any one of claims 1 to 6 wherein the substrate has two surfaces (12, 22), wherein the first and the second surfaces (12, 22) have a plurality of board pad patterns (14) formed of board pads (16).

14. A method of evaluating one or more aspects of a surface mount technology system using the evaluation board (10) of any one of claims 1 to 13 wherein said method comprises the steps of:
passing the evaluation board (10) through at least one stage of a surface mount technology process; and
inspecting the board (10) on completion of said at least one stage of the surface mount technology process.

15. A stencil for an evaluation board as claimed in any one of claims 1 to 5, wherein the stencil comprises a plurality of apertures having sizes and spacing that correspond with the board pad sizes and pad-to-pad spacing of the board pads on the evaluation board.

## Patentansprüche

1. Testplatte (10) zum Testen eines oder mehrer Aspekte(s) eines Systems der Oberflächenmontagetechnologie, wobei die Platte Folgendes umfasst:
ein Substrat mit einer Oberfläche (12);
eine Mehrzahl von Leiterplatten-Lötaugenmustern (14), die auf der Oberfläche (12) ausgebildet sind, wobei mindestens einige der Leiterplatten-Lötaugenmuster (14) in einer Matrix angeordnet sind und jede der Leiterplatten-Lötaugenmuster (14) in der Matrix eine Mehrzahl von Leiterplatten-Lötaugen (16) umfasst, wobei die Leiterplatten-Lötaugen (16) eine einheitliche Form, Größe und Abstand zueinander aufweisen.
**dadurch gekennzeichnet, dass** für jedes Leiterplatten-Lötaugenmuster (14) in der Matrix die Leiterplatten-Lötaugen (16) in meheren Reihen und Spalten angeordnet sind und die Größe und/oder Abstand der zwischen den Leiterplatten-Lötaugen (16) benachbarter Leiterplatten-Lötaugenmuster (14) sich im Verlauf der Matrix progressiv ändert.

2. Testplatte (10) gemäß Anspruch 1, wobei die Form der Leiterplatten-Lötaugen (16) von mindestens einem der Mehrzahl von Leiterplatten-Lötaugenmustern (14) von der Form der Leiterplatten-Lötaugen (16) von mindestens einem anderen der Mehrzahl von Leiterplatten-Lötaugenmustern (14) abweicht.

3. Testplatte (10) gemäß einem der Ansprüche 1 oder 2, wobei ein Teil der Leiterplatten-Lötaugenmuster (14) in einer zweidimensionalen Matrix mit Reihen und Spalten von Leiterplatten-Lötaugenmustern (14) angeordnet ist, wobei, in jeder Reihe der Matrix, eine Eigenschaft der Leiterplatten-Lötaugen (16) von benachbarten Leiterplatten-Lötaugenmustern (14) in dieser Reihe variiert und wobei in jeder Spalte der Matrix, eine Eigenschaft der Leiterplatten-Lötaugen (16) von benachbarten Leiterplatten-Lötaugenmustern (14) in dieser Spalte variiert.

4. Testplatte (10) gemäß Anspruch 3, wobei die Eigenschaft der Leiterplatten-Lötaugenmuster (14) der Reihen und Spalten der Matrix die Form, die Größe oder den Abstand der Leiterplatten-Lötaugen (16) der Leiterplatten-Lötaugenmuster (14) oder eine Kombination daraus umfasst.

5. Testplatte (10) gemäß Anspruch 3 oder Anspruch 4, wobei die Eigenschaft der Leiterplatten-Lötaugen (16) der Leiterplatten-Lötaugenmuster (14) in den Reihen der Matrix, die variiert, verschieden ist von der Eigenschaft, die bei den Leiterplatten-Lötaugen (16) der Leiterplatten-Lötaugenmuster (14) in den Spalten der Matrix variiert.

6. Testplatte (10) gemäß einem der Ansprüche 1 bis 5, wobei das Substrat zwei Oberflächen (12, 22) besitzt und wobei jede Oberfläche (12, 22) eine Mehrzahl von darauf ausgebildeten Leiterplatten-Lötaugenmustern (14) aufweist.

7. Testplatte (10) gemäß einem der Ansprüche 1 bis 6, wobei das Substrat zwei Oberflächen (12, 22) besitzt und wobei die erste Oberfläche (12) eine Mehrzahl von Leiterplatten-Lötaugenmustern (14) aus Leiterplatten-Lötaugen (16) aufweist und die zweite Oberfläche (22) eine Mehrzahl von vollflächigen Leiterplatten-Lötaugen (24) aufweist.

8. Testplatte (20) gemäß Anspruch 7, wobei sich die Größe und/oder der Abstand von benachbarten vollflächigen Leiterplatten-Lötaugen (24) progressiv ändert.

9. Testplatte (20) gemäß Anspruch 7 oder Anspruch 8, wobei ein Teil der vollflächigen Leiterplatten-Lötaugen (24) in einer Matrix angeordnet ist, in der sich die Größe und/oder der Abstand der Lötaugen benachbarter vollflächiger Leiterplatten-Lötaugen (24) im Verlauf der Matrix progressiv ändert.

10. Testplatte (20) gemäß einem der Ansprüche 7 bis 9, wobei ein Teil der vollflächigen Leiterplatten-Lötaugen (24) in einer zweidimensionalen Matrix mit Reihen und Spalten von solchen vollflächigen Leiterplatten-Lötaugen (24) angeordnet ist, wobei in jeder Reihe der Matrix eine Eigenschaft von benachbarten vollflächigen Leiterplatten-Lötaugen (24) in dieser Reihe variiert und wobei in jeder Spalte der Matrix eine Eigenschaft von benachbarten vollflächigen Leiterplatten-Lötaugen (24) in dieser Spalte variiert.

11. Testplatte (20) gemäß Anspruch 10, wobei die Eigenschaft der vollflächigen Leiterplatten-Lötaugen (24) in den Reihen der Matrix, die variiert, verschieden ist von der Eigenschaft, die bei den vollflächigen Leiterplatten-Lötaugen (24) in den Spalten der Matrix variiert.

12. Testplatte (20) gemäß einem der Ansprüche 7 bis 11, wobei das Substrat zwei Oberflächen (22) besitzt und wobei jede Oberfläche eine Mehrzahl von darauf ausgebildeten vollflächigen Leiterplatten-Lötaugen (24) aufweist.

13. Testplatte (10) gemäß Anspruch 1 bis 6, wobei das Substrat zwei Oberflächen (12, 22) besitzt und wobei die erste und die zweite Oberfläche (12, 22) eine Mehrzahl von Leiterplatten-Lötaugenmustern (14) aufweist, welche aus Leiterplatten-Lötaugen (16) gebildet sind.

14. Verfahren zum Testen eines oder mehrer Aspekte(s) eines Systems der Oberflächenmontagetechnologie mithilfe der Testplatte (10) gemäß einem der Ansprüche 1 bis 13, wobei das Verfahren die folgenden Schritte umfasst:
die Testplatte (10) mindestens einer Stufe eines Prozesses der Oberflächenmontagetechnologie unterziehen; und
die Testplatte (10) nach Ende dieser mindestens einen Stufe des Prozesses der Oberflächenmontagetechnologie überprüfen.

15. Schablone für eine Testplatte gemäß Anspruch 1 bis 5, wobei die Schablone eine Mehrzahl von Öffnungen in Größen und Abständen umfasst, die den Größen der Leiterplatten-Lötaugen und den Abständen zwischen den Leiterplatten-Lötaugen auf der Testplatte entsprechen.

## Revendications

1. Plaque d'essai (10) servant à évaluer un ou plusieurs aspect(s) d'un système de technologie de montage en surface, la plaque comprenant :
un substrat ayant une surface (12) ;
une pluralité de motifs de pastilles de plaque (14) formés sur la surface (12), au moins certains motifs de pastilles de plaque (14) étant agencés en une matrice, chaque motif de pastilles de plaque (14) dans la matrice comprenant une pluralité de pastilles de plaque (16) ayant une forme, une taille et un espacement entre pastilles uniformes,
se caractérisant en cela que, pour chaque dit motif de pastilles de plaque (14) dans la matrice, les pastilles de plaque (16) sont agencées en plusieurs rangées et colonnes et en cela que la taille et/ou l'espacement entre pastilles des pastilles de plaque (16) de motifs de pastilles de plaque adjacents (14) évoluent progressivement d'un bout à l'autre de la matrice.

2. Plaque d'essai (10) de la revendication 1 dans laquelle la forme des pastilles de plaque (16) d'au moins un motif parmi la pluralité de motifs de pastilles de plaque (14) diffère de la forme des pastilles de plaque (16) d'au moins un autre motif parmi la pluralité de motifs de pastilles de plaque (14).

3. Plaque d'essai (10) de l'une quelconque des revendications 1 à 2 dans laquelle certains motifs de plaque d'essai (14) sont agencés en une matrice bidimensionnelle présentant des rangées et des colonnes de motifs de pastilles de plaque (14) dans laquelle, dans chaque rangée de la matrice, une variation de caractéristique est appliquée aux pastilles de plaque (16) des motifs de pastilles de plaque (14) adjacents de cette rangée et dans laquelle, pour chaque colonne de la matrice, une variation est appliquée à la caractéristique des pastilles de plaque (16) des motifs de pastilles de plaque (14) adjacents de cette colonne.

4. Plaque d'essai (10) de la revendication 3 dans laquelle la caractéristique des motifs de pastilles de plaque (14) des rangées et colonnes de la matrice comprend un ou plusieurs élément(s) d'une combinaison de forme, taille ou espacement entre pastilles des pastilles de plaque (16) desdits motifs de pastilles de plaque (14).

5. Plaque d'essai (10) de la revendication 3 ou 4 dans laquelle la caractéristique des pastilles de plaque (16) des motifs de pastilles de plaque (14) des rangées de la matrice, à laquelle une variation est appliquée, diffère de la caractéristique, à laquelle une variation est appliquée, pour les pastilles de plaque (16) des motifs de pastilles de plaque (14) des colonnes de la matrice.

6. Plaque d'essai (10) de l'une quelconque des revendications 1 à 5 dans laquelle le substrat a deux surfaces (12, 22), chaque surface (12, 22) ayant une pluralité de motifs de pastilles de plaque (14) formés sur elle.

7. Plaque d'essai (10) de l'une quelconque des revendications 1 à 6 dans laquelle le substrat a deux surfaces (12, 22), la première surface (12) ayant une pluralité de motifs de pastilles de plaque (14) formés de pastilles de plaque (16), la deuxième surface (22) ayant une pluralité de pastilles de plaque à surface remplie (24).

8. Plaque d'essai (20) de la revendication 7 dans laquelle la taille et/ou l'espacement entre pastilles des pastilles de plaque à surface remplie (24) adjacentes évolue(nt) progressivement.

9. Plaque d'essai (20) de la revendication 7 ou 8 dans laquelle au moins certaines pastilles de plaque à surface remplie (24) sont agencées en une matrice, la taille et/ou l'espacement entre pastilles des pastilles de plaque à surface remplie (24) adjacentes évoluant progressivement d'un bout à l'autre de la matrice.

10. Plaque d'essai (20) de l'une quelconque des revendications 7 à 9 dans laquelle certains motifs de plaque à surface remplie (24) sont agencés en une matrice bidimensionnelle constituée de rangées et de colonnes desdites pastilles de plaque à surface remplie (24), dans laquelle, dans chaque rangée de la matrice, une variation de caractéristique est appliquée aux pastilles de plaque à surface remplie (24) de cette rangée et dans laquelle, pour chaque colonne de la matrice, une variation de caractéristique est appliquée aux pastilles de plaque à surface remplie (24) de cette colonne.

11. Plaque d'essai (20) de la revendication 10 dans laquelle la caractéristique des pastilles de plaque à surface remplie (24) des rangées de la matrice, à laquelle une variation est appliquée, diffère de la caractéristique, à laquelle une variation est appliquée, pour les pastilles de plaque à surface remplie (24) des colonnes de la matrice.

12. Plaque d'essai (20) de l'une quelconque des revendications 7 à 11 dans laquelle le substrat a deux surfaces (22), chaque surface ayant une pluralité de pastilles de plaque à surface remplie (24) formées sur elle.

13. Plaque d'essai (10) de l'une quelconque des revendications 1 à 6 dans laquelle le substrat a deux surfaces (12, 22), les première et deuxième surfaces (12, 22) ayant une pluralité de motifs de pastilles de plaque (14) formés de pastilles de plaque (16).

14. Procédé pour tester un ou plusieurs aspect(s) d'un système de technologie de montage en surface utilisant la plaque d'essai (10) de l'une quelconque des revendications 1 à 13, ledit procédé comportant les étapes suivantes :
soumettre la plaque d'essai (10) à au moins une étape d'un processus de technologie de montage en surface ; et
inspecter la plaque (10) à l'issue de ladite/desdites étape(s) de processus de technologie de montage en surface.

15. Un typon pour une plaque d'essai telle que revendiquée dans l'une quelconque des revendications 1 à 5, le typon comprenant une pluralité d'ouvertures ayant des tailles et des espacements qui correspondent aux tailles de pastilles de plaque et à l'espacement entre pastilles des pastilles de plaque sur la plaque d'essai.
